(19) Europäisches Patentamt
European Patent Office
Office européen des brevets

(11) **EP 3 107 283 A1**

(12) **EUROPEAN PATENT APPLICATION**
published in accordance with Art. 153(4) EPC

(43) Date of publication:
**21.12.2016 Bulletin 2016/51**

(51) Int Cl.:
*H04N 7/01* *(2006.01)*

(21) Application number: **14888240.0**

(22) Date of filing: **04.11.2014**

(86) International application number:
**PCT/KR2014/010478**

(87) International publication number:
**WO 2015/152485 (08.10.2015 Gazette 2015/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.03.2014 KR 20140037494**

(71) Applicant: **Nextchip Co. Ltd.**
**Seongnam-si, Gyeonggi-do 463-400 (KR)**

(72) Inventors:
• **KIM, Do Kyun**
**Seoul 139-849 (KR)**
• **SONG, Jin Gun**
**Seoul 135-961 (KR)**
• **KIM, Dong Han**
**Seoul 139-956 (KR)**

(74) Representative: **Taylor, Adam David**
**Dehns**
**St Bride's House**
**10 Salisbury Square**
**London EC4Y 8JD (GB)**

(54) **METHOD AND APPARATUS FOR TRANSMITTING VIDEO SIGNAL**

(57)    Provided are a method and an apparatus for transmitting a video signal, the method converting a digital video signal into an analog video signal. The method and apparatus for transmitting a video signal determine the specification of an analog video signal transmission, convert the digital timing of a digital video signal on the basis of the determined specification, convert the converted digital video signal into an analog video signal, and transmit the converted analog video signal.

**FIG. 3**

```
            START

RECEIVE DIGITAL VIDEO SIGNAL          ~310

DETERMINE SPEC OF ANALOG VIDEO SIGNAL ~320

CONVERT FIRST DIGITAL TIMING OF DIGITAL
VIDEO SIGNAL TO SECOND DIGITAL TIMING  ~330
BASED ON SPEC

CONVERT DIGITAL VIDEO SIGNAL TO
ANALOG VIDEO SIGNAL                    ~340

TRANSMIT ANALOG VIDEO SIGNAL           ~350

            END
```

**Description**

TECHNICAL FIELD

Example embodiments relate to technology for transmitting a video signal, and more particularly, to technology for converting a digital video signal to an analog video signal and transmitting the analog video signal.

RELATED ART

A video transmission method may include a method of using an open circuit and a method of using a closed circuit. Since a video transmission method using an open circuit is to transmit video signals to a plurality of unspecific users, a standardized scheme may be employed to transmit a video. On the other hand, since a video transmission method using a closed circuit is to transmit a video signal only to a specific user, only the specific user may be aware of a video signal transmission scheme.

In general, a composite signal used in a closed-circuit system follows a standard method about an analog color television (TV). Since the standard method uses a limited frequency band, an alternating color issue and a luminance inclusion issue may occur.

Korean Patent Publication No. 10-2006-0063723, published on December 5, 2005, discloses the invention relating to a video signal processing device and a video signal transmission method. This invention may be applied to display a national television system committee (NTSC)-based video signal, thereby effectively avoiding displaying of an unnatural edge and efficiently processing a video signal having a relatively high frame frequency through a simple configuration. In the published invention, a center value of a temporal axis in a single frame of a color difference signal is set to be closest to a center value of a temporal axis in a plurality of frames of a luminance signal corresponding to the color difference signal, and the single frame of the color difference signal is allocated to the plurality of frames of the luminance signal.

DETAILED DESCRIPTION

TECHNICAL SUBJECT

Example embodiments provide an apparatus and method for transmitting a video signal.

Example embodiments also provide an apparatus and method for transmitting an analog video signal by converting a digital video signal to the analog video signal.

SOLUTION

According to an aspect, there is provided a video signal transmission method for converting a digital video signal to an analog video signal, the method including determining a specification (spec) for transmitting the analog video signal, converting a first digital timing of the digital video signal to a second digital timing based on the spec, converting the digital video signal to the analog video signal, and transmitting the analog video signal.

The converting of the first digital timing to the second digital timing may include converting the first digital timing to the second digital timing based on a type of the digital video signal.

The type of the digital video signal may be at least one of a type in which a luminance signal and a color difference signal are separated and a type in which the luminance signal and the color difference signal are mixed.

The converting of the first digital timing to the second digital timing may include converting the first digital timing to the second digital timing based on a frame rate of the digital video signal.

The converting of the first digital timing to the second digital timing may include converting the first digital timing to the second digital timing so that the second digital timing is consistent with respect to the spec.

The converting of the first digital timing to the second digital timing may further include determining a system frequency based on the spec, and generating the system frequency.

The converting of the first digital timing to the second digital timing may include converting the first digital timing to the second digital timing based on the system frequency.

The generating of the system frequency may include generating the system frequency using a phase locked loop (PLL).

The converting of the first digital timing to the second digital timing may further include determining the second digital timing based on the system frequency.

The converting of the first digital timing to the second digital timing may include converting the first digital timing to the second digital timing by changing the number of samples in a blank area of the digital video signal.

The number of samples in the blank area may be determined based on the system frequency.

The system frequency may be determined based on the spec.

A horizontal frequency of the digital video signal may vary in response to converting the first digital timing to the second digital timing.

The video signal transmission method may further include receiving the digital video signal.

The receiving of the digital video signal may include receiving the digital video signal by synchronizing the digital video signal to an input clock.

The video signal transmission method may further include modulating a color difference frequency signal of the digital video signal using a subcarrier.

The transmitting of the analog video signal may include transmitting the analog video signal that includes the modulated color difference frequency signal.

According to another aspect, there is provided a video signal transmission apparatus for converting a digital video signal to an analog video signal, the apparatus including a processor configured to determine a spec for transmitting the analog video signal, to convert a first digital timing of the digital video signal to a second digital timing based on the spec, and to convert the digital video signal to the analog video signal, and a communicator configured to transmit the analog video signal.

EFFECT

According to example embodiments, there may be provided a video signal transmission apparatus and method.

Also, according to example embodiments, there may be provided an apparatus and method for transmitting a video signal by converting a digital video signal to an analog video signal.

Also, according to example embodiments, there may be provided a video signal transmission apparatus and method for converting a digital video signal based on a specification (spec) for transmitting an analog video signal, and converting the converted digital video signal to the analog video signal.

BRIEF DESCRIPTION OF DRAWINGS

FIG. 1 illustrates an example of a method of transmitting a video signal according to example embodiments;
FIG. 2 is a block diagram illustrating a configuration of a video signal transmission apparatus according to example embodiments;
FIG. 3 is a flowchart illustrating a video signal transmission method according to example embodiments;
FIG. 4 is a flowchart illustrating a method of converting a digital timing according to example embodiments;
FIG. 5 illustrates an example of a timing specification (spec) of vertical lines according to example embodiments;
FIG. 6 illustrates an example of a spec of a digital video signal according to example embodiments;
FIG. 7 illustrates an example of a waveform of an analog video signal before conversion and a waveform of an analog video signal after conversion according to example embodiments;
FIG. 8 is a flowchart illustrating a method of modulating a color difference frequency signal using a subcarrier according to example embodiments; and
FIG. 9 illustrates an example of an analog video signal according to example embodiments.

MODE

Hereinafter, some example embodiments will be described in detail with reference to the accompanying drawings. Like reference numerals in the drawings refer to like elements throughout the present specification.

Various modifications may be made to the example embodiments. However, it should be understood that these embodiments are not construed as limited to the illustrated forms and include all changes, equivalents or alternatives within the idea and the technical scope of this disclosure.

The terminology used herein is for the purpose of describing particular example embodiments only and is not intended to be limiting. As used herein, the singular forms "a," "an" and "the" are intended to include the plural forms as well, unless the context clearly indicates otherwise. It will be further understood that the terms "comprise/include" and/or "have," when used in this specification, specify the presence of stated features, integers, steps, operations, elements, components or combinations thereof, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which these example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Regarding the reference numerals assigned to the elements in the drawings, it should be noted that the same elements will be designated by the same reference numerals, wherever possible, even though they are shown in different drawings. Also, in the description of embodiments, detailed description of well-known related structures or functions will be omitted when it is deemed that such description will cause ambiguous interpretation of the present disclosure.

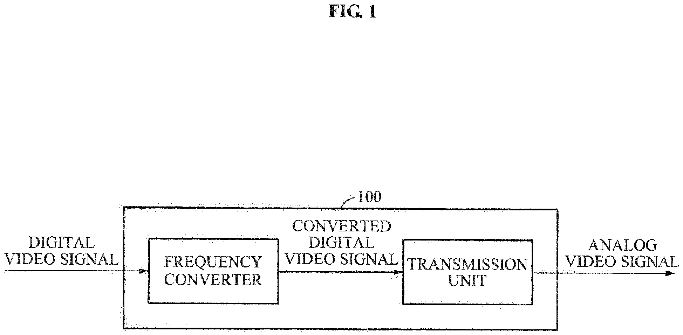

FIG. 1 illustrates an example of a method of transmitting a video signal according to example embodiments.

A video signal transmission apparatus 100 may transmit a video signal. Hereinafter, the video signal transmission apparatus 100 will be abbreviated as the apparatus 100.

According to an aspect, the apparatus 100 may be included in a closed-circuit system. That is, the apparatus 100 may be the entire of or a portion of the closed-circuit system.

According to an aspect, the apparatus 100 may receive a digital video signal. For example, the apparatus 100 may receive a digital video signal from a camera that photographs a digital video.

The apparatus 100 may process the digital video signal. For example, processing of a digital video signal may indicate converting a frequency of the digital video signal or converting a digital timing of the digital video signal.

The apparatus 100 may convert the digital video signal to an analog video signal. The apparatus 100 may transmit the analog video signal to a video signal reception apparatus that receives a video signal

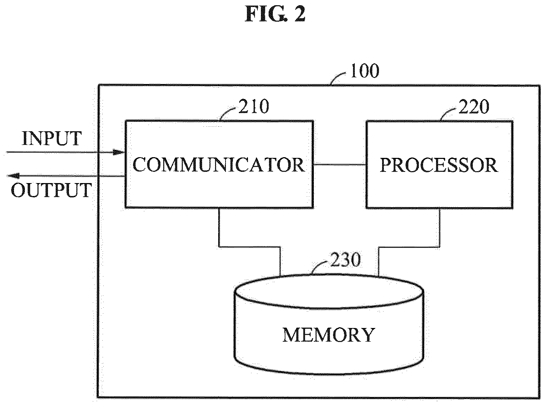

A video signal transmission method for converting the digital video signal to the analog video signal is described with reference to FIGS. 2 through 8.

FIG. 2 is a block diagram illustrating a configuration of a video signal transmission apparatus according to example embodiments.

Referring to FIG. 2, the apparatus 100 may include a communicator 210, a processor 220, and a memory 230.

The communicator 210 may transmit and receive a video signal.

The processor 220 may process the video signal received at the communicator 210.

The memory 230 may store the video signal received at the communicator 210, and may store the video signal processed at the processor 220.

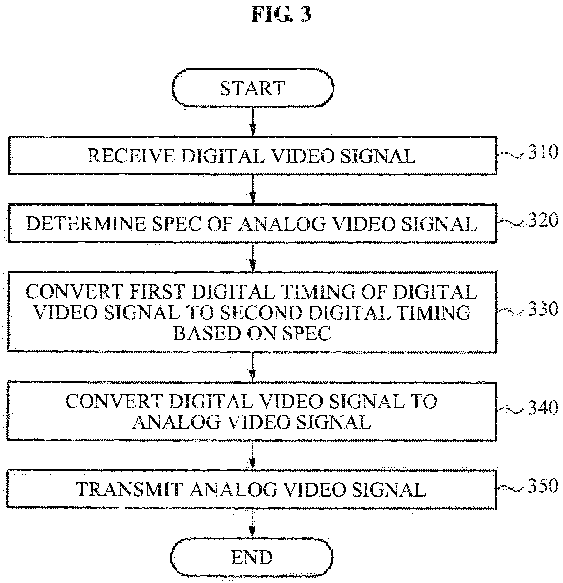

The communicator 210, the processor 220, and the memory 230 are described with reference to FIGS. 3 through 8.

The technical description made above with reference to FIG. 1 may be applicable as is and thus, further description will be omitted.

FIG. 3 is a flowchart illustrating a video signal transmission method according to example embodiments.

In operation 310, the communicator 210 may receive a video signal. The video signal may be a digital video signal or an analog video signal.

Contents regarding a specification (spec) of the digital video signal are disclosed in Table 1 and Table 2. Table 1 shows the spec associated with transmission of a high definition (HD) digital video signal.

[Table 1]

| Total resolution | Frame rate | Sampling rate (MHz) |
|---|---|---|
| 1650x750p | 60 | 74.25 |
| 1980x750p | 50 | 74.25 |
| 1650x750p | 30 | 37.125 |
| 1980x750p | 25 | 37.125 |

Table 2 shows the spec associated with transmission of a full HD (FHD) digital video signal.

[Table 2]

| Total resolution | Frame rate | Sampling rate (MHz) |
|---|---|---|
| 2200x1125p | 60 | 148.5 |
| 2200x1250p | 50 | 148.5 |
| 2200x1125p | 30 | 74.25 |
| 2200x1250p | 25 | 74.25 |

The total resolution, the frame rate, and the sampling rate may have the following relationship as expressed by Equation 1]

[Equation 1]

$$\text{Sampling rate} = \text{total resolution (number of samples)} * \text{frame rate}$$

The sample may denote a pixel. According to another aspect, the sample may denote a block that is configured as a set of two or more pixels.

The spec of the digital video signal may be a spec about one of standard definition (SD), HD, FHD, and ultra HD (UHD).

For example, Table 1 may relate to a spec about 720p HD. 720p may be the spec in which the number of vertical lines in an active area is 720 and a type of a scanning line is progressive. The active area may be an area on which a video to be delivered to a viewer is to be displayed.

As another example, Table 2 may relate to a spec about 1080p FHD. 1080p may be the spec in which the number of vertical lines in an active area is 1080 and a type of a scanning line is progressive.

The type of the digital video signal may be a type in which a luminance signal and a color difference signal are separated or a type in which the luminance signal and the color difference signal are mixed. The type in which the luminance signal and the color difference signal are separated may use 16 bits. The type in which the luminance signal and the color difference signal may use 8 bits.

The type in which the luminance signal and the color difference signal are mixed may have a bit string as expressed by Table 3.

[Table 3]

| FF 00 00 XY 80 10 80 10 FF 00 00 XY CB Y CR Y |
| --- |

A digital timing may be detected through XY of "FF 00 00 XY". The luminance signal and the color difference signal may be transmitted through the same path.

The type in which the luminance signal and the color difference signal are separated may have bit strings as expressed by Table 4.

[Table 4]

| Luminance signal | FF 00 00 XY 80 80 ............. FF 00 00 XY Y Y Y Y Y Y |
| --- | --- |
| Color difference signal | FF 00 00 XY 80 80 ............. FF 00 00 XY CB CR CB CR CB CR |

In the case of the type in which the luminance signal and the color difference signal are separated, the luminance signal and the color difference signal may be transmitted through the respective paths.

According to an aspect, the communicator 210 may receive the digital video signal from the closed-circuit system.

The communicator 210 may receive the digital video signal by synchronizing the digital video signal to an input clock.

A clock about the type in which the luminance signal and the color difference signal are separated may be faster by two times than a clock about the type in which the luminance signal and the color difference signal are mixed.

When the clock about the type in which the luminance signal and the color difference signal are separated is faster by two times than the clock about the type in which the luminance signal and the color difference signal are mixed, the communicator 210 may receive the same amount of data during the same period of time. For example, when an input frequency of a 16-bit video signal is 74.25 MHz, an input frequency of an 8-bit video signal may be 148.5 MHz.

The communicator 210 may receive a digital video signal of which an input frequency varies based on a frame rate of the digital video signal. For example, an input frequency of a digital video signal having a frame rate of 50 may be two times of an input frequency of a digital video signal having a frame rate of 25. For example, when the input frequency of the digital video signal having the frame rate of 50 is 74.25 MHz, the input frequency of the digital video signal having the frame rate of 25 may be 37.125 MHz.

In operation 320, the processor 220 may determine a spec for transmitting an analog video signal.

According to an aspect, the spec for transmitting the analog video signal may be a spec about SD. For example, the spec for transmitting the analog video signal may be 720p. When the spec is 720p, the number of samples in a single line may be 1280. As another example, the spec for transmitting the analog video signal may be 1080p. When the spec is 1080p, the number of samples in a single line may be 1920.

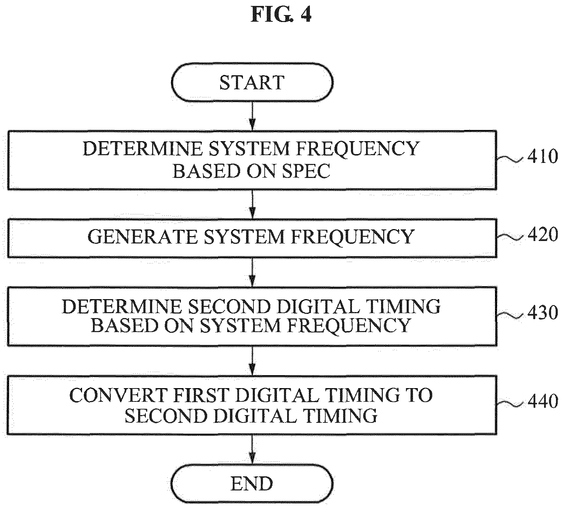

The spec for transmitting the analog video signal is described with reference to FIG. 4.

In operation 330, the processor 220 may convert a first digital timing of the digital video signal to a second digital timing based on the determined spec.

The first digital timing may be the digital timing detected in operation 310. That is, the processor 220 may detect the first digital timing through a bit string of the digital video signal.

According to an aspect, the processor 220 may convert the first digital timing to the second digital timing based on the type of the digital video signal.

According to another aspect, the processor 220 may convert the first digital timing to the second digital timing based on the frame rate of the digital video signal.

The processor 220 may convert the first digital timing to the second digital timing so that the second digital timing is consistent with respect to the determined spec. That is, a plurality of converted digital video signals may have the same second digital timing with respect to the same spec. For example, the second digital timing may be a digital timing corresponding to the spec of 1280x720p. As another example, the second digital timing may be a digital timing corresponding to the spec of 1920x1080p.

The first digital timing and the second digital timing are described with reference to FIG. 4.

In operation 340, the processor 220 may convert the digital video signal to the analog video signal.

In operation 350, the communicator 210 may transmit the converted analog video signal.

Through operations 320 through 350, the digital video signal may be transmitted as the analog video signal.

The technical description made above with reference to FIGS. 1 and 2 may be applicable as is and thus, further description will be omitted.

FIG. 4 is a flowchart illustrating a method of converting a digital timing according to example embodiments.

Operation 330 of FIG. 3 may include operations 410 through 440 of FIG. 4.

In operation 410, the processor 220 may determine a system frequency based on the determined spec. For example, when the spec is 720p, the number of samples in a single line may be 1280. When the number of samples is 1280, the system frequency may be determined as 24 MHz. As another example, when the number of samples is 1440, the system frequency may be determined as 27 MHz. As another example, when the number of samples is 1920, the system frequency may be determined as 36 MHz.

In operation 420, the processor 220 may generate the system frequency. For example, the processor 220 may generate the system frequency using a phase locked loop (PLL).

In operation 430, the processor 220 may determine the second digital timing based on the system frequency. The processor 220 may determine the second digital timing so that the digital video signal corresponds to the system frequency.

In operation 440, the processor 220 may convert the first digital timing of the digital video signal to the second digital timing. For example, the processor 220 may convert the first digital timing to the second digital timing based on the system frequency.

According to an aspect, the processor 220 may convert the first digital timing to the second digital timing by changing the number of samples in a blank area of the digital video signal. The processor 220 may adjust the second digital timing by adjusting the number of samples in the blank area of the digital video signal. The processor 220 may determine the number of samples in the blank area to be adjusted based on at least one of a frame rate and a sampling rate of the digital video signal.

For example, when a digital video signal of which a frame rate is 25 and of which a total number of vertical lines is 750 is received at an input frequency of 74.25 MHz, valid data may be 37.125 MHz corresponding to a half of the input frequency. Assuming the system frequency as 37.125Mhz, the number of samples in a single line may be calculated according to Equation 2.

[Equation 2]

$$\text{Number of samples} = \text{system frequency}/(\text{frame rate}*\text{total number of vertical lines})$$

That is, 37125000/ (25*750) = 1980.

When the spec for transmitting the analog video signal is 720p, the number of samples is 1280. Thus, the number of samples in the blank area may be 700.

The processor 220 may convert the first digital timing to the second digital timing by adjusting the number of samples in the blank area, for example, 700 samples.

In response to converting the first digital timing to the second digital timing, a horizontal frequency of the digital video signal may vary.

The technical description made above with reference to FIGS. 1 through 3 may be applicable as is and thus, further description will be omitted.

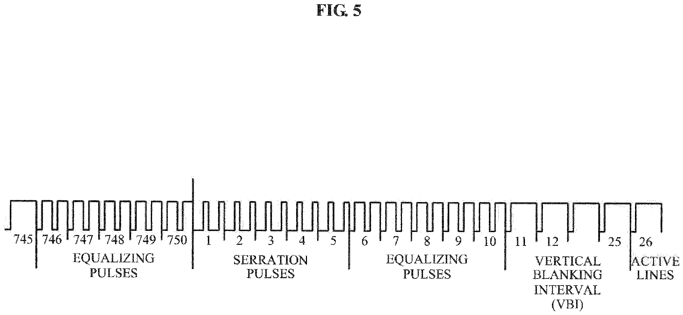

FIG. 5 illustrates an example of a timing spec of vertical lines according to example embodiments.

For example, FIG. 5 illustrates 750 lines that are lines in the vertical direction, that is, vertical lines. The lines may be lines from an upper end of a video to a lower end of a video. That is, line 1 may be an uppermost line.

Lines 1 through 5 may be serration pulses. A serration pulse may be a vertical synchronization pulse.

Lines 6 through 10 may be post-equalizing pulses. An equalizing pulse may be a pulse used to accurately perform interlaced scanning. Line 746 through 750 may be pre-equalizing pulses.

Lines 11 through 25 may be a vertical blanking interval (VBI).

Lines 26 through 745 may be active lines. An actual video signal may be included in the active lines.

Although FIG. 5 illustrates a timing spec in which the number of vertical lines is 750, the description of FIG. 5 may be similarly modified and applicable to a timing spec in which the number of vertical lines is 1125 and a timing spec in which the number of vertical lines is 1250.

For example, when the number of vertical lines is 1125, lines 1 through 5 may be serration pulses, lines 6 through 10 may be post-equalizing pulses, lines 11 through 40 may be a VBI, lines 41 through 1120 may be active lines, and lines 1121 through 1125 may be pre-equalizing pulses.

As another example, when the number of vertical lines is 1250, lines 1 through 5 may be serration pulses, lines 6 through 10 may be post-equalizing pulses, lines 11 through 165 may be a VBI, lines 166 through 1245 may be active lines, and lines 1246 through 1250 may be pre-equalizing pulses.

The technical description made above with reference to FIGS. 1 through 4 may be applicable as is and thus, further description will be omitted.

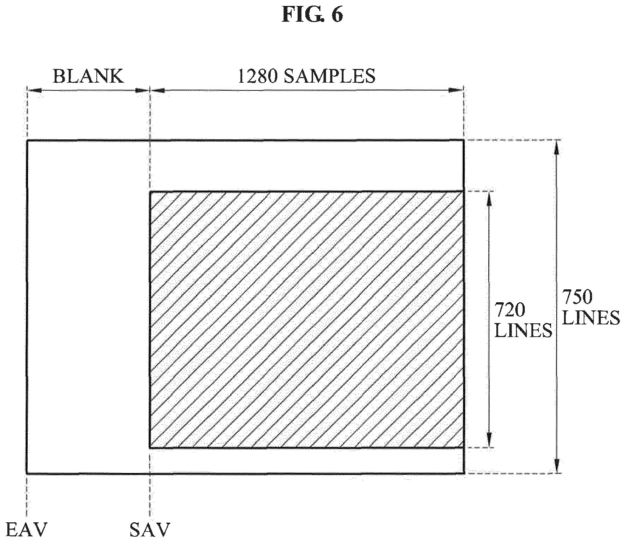

FIG. 6 illustrates an example of a spec of a digital video signal according to example embodiments.

Referring to FIG. 6, the digital video signal may include vertical lines, and may include a blank area and an active area in a horizontal direction. An area indicated with deviant cease lines may be an active area.

In the horizontal direction, the blank area may indicate an area from an end of active video signal (EVA) to a start of active video signal (SAV). In a single line, a length of the blank area may be adjusted based on the number of samples included in the blank area.

According to an aspect, the processor 220 may adjust the number of samples included in the blank area. For example, the processor 220 may reduce the length of the blank area by reducing the number of samples included in the blank area.

When the length of the blank area is reduced, an active period may be reduced.

Although a first digital timing of the digital video signal is converted to a second digital timing, the number of lines may not vary. For example, regardless of a change in the number of samples in the blank area, a total number of lines of the digital video signal may be 750 and the number of active lines may be 720.

According to an aspect, when the number of active lines is 720, the number of samples of an active area included in a single active line may be 1280.

Although FIG. 6 illustrates the spec of the digital video signal having 750 vertical lines, the description of FIG. 6 may be similarly modified and applicable to a spec of a digital video signal having 1125 vertical lines and a spec of a digital video signal having 1250 vertical lines.

For example, the number of active lines of a digital video signal having 1125 or 1250 vertical lines may be 1080. When the number of active lines is 1080, the number of samples of an active area included in a single active line may be 1920.

The technical description made above with reference to FIGS. 1 through 5 may be applicable as is and thus, further description will be omitted.

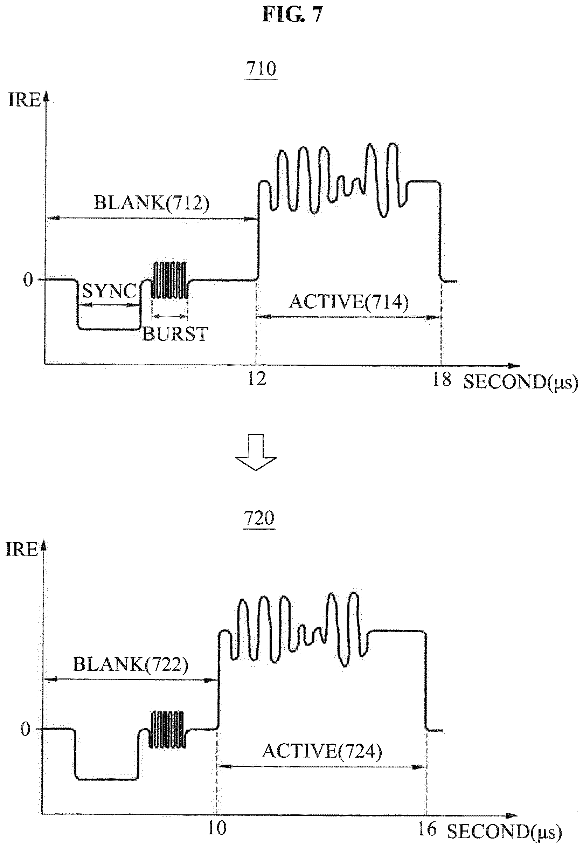

FIG. 7 illustrates an example of a waveform of an analog video signal before conversion and a waveform of an analog video signal after conversion according to example embodiments.

A waveform 710 of an analog video signal may be a waveform before a change in the number of samples in a blank area 712 occurs. That is, the waveform 710 may be a waveform of the analog video signal corresponding to the digital video signal received in operation 320.

A waveform 720 of an analog video signal may be a waveform after a change in the number of blank samples occurs. That is, the waveform 720 may be a waveform of the analog video signal converted in operation 340.

Sync may denote a horizontal synchronous signal, and may be used to generate a horizontal reference signal when demodulating a video.

Burst may denote a color difference restoring signal, and may provide phase and amplitude reference about color information when demodulating a video.

For example, the number of samples in a blank area of a digital video signal corresponding to the waveform 710 may decrease. When the number of samples in the blank area is reduced, an interval of a blank area 722 may be less than an interval of a blank area 712. An interval of an active area 714 may be same as an interval of an active area 724. Thus, a length of the active area 724 may be less than a length of the active area 714. A frequency of the waveform 720 may be greater than a frequency of the waveform 710.

The technical description made above with reference to FIGS. 1 through 6 may be applicable as is and thus, further description will be omitted.

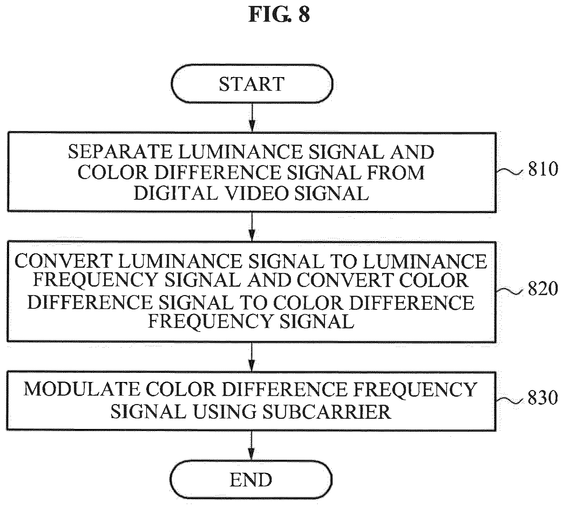

FIG. 8 is a flowchart illustrating a method of modulating a color difference frequency signal using a subcarrier according to example embodiments.

Operations 810 through 830 may be performed after operation 330.

In operation 810, the processor 220 may separate a luminance signal and a color difference signal from a digital video signal. When separating the color difference signal, the processor 220 may separate the color difference signal using an efficient color conversion algorithm. For example, the color conversion algorithm may be an algorithm for converting a form of YCBCR to a form of YUV (YIQ).

In operation 820, the processor 220 may convert the luminance signal to a luminance frequency signal, and may convert the color difference signal to a color difference frequency signal. The processor 220 may convert the luminance signal to the luminance frequency signal so that the luminance frequency signal uses the entire frequency domain.

The processor 220 may generate the luminance frequency signal using a luminance filter.

The processor 220 may generate the color difference frequency signal using a color difference filter.

In operation 830, the processor 220 may modulate the color difference frequency signal of the digital video signal using a subcarrier. A frequency of the subcarrier may be determined using a frequency interleaving method.

According to an aspect, the processor 220 may modulate the color difference frequency signal so that the luminance frequency signal and the modulated color difference frequency signal do not overlap. For example, when the luminance frequency signal has a frequency band of 0 to 9 MHz, the processor 220 may modulate the color difference frequency signal so that the color difference frequency signal may have a frequency band of 10 MHz to 12 MHz.

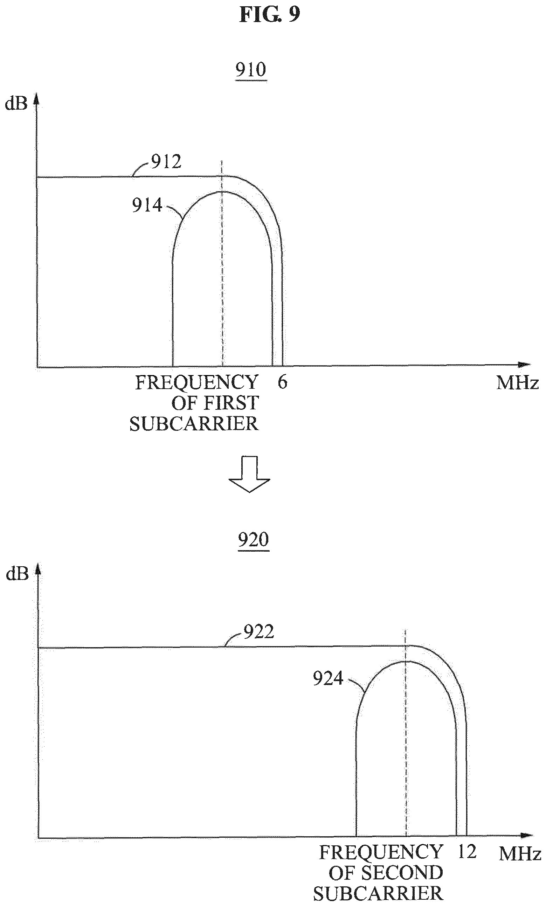

According to another aspect, the processor 220 may modulate the color difference frequency signal so that a frequency band of the luminance frequency signal may include a frequency band of the modulated color difference frequency signal. Modulating the color difference frequency signal so that the frequency band of the luminance frequency band includes the frequency band of the modulated color difference frequency signal is described with reference to FIG. 9.

The processor 220 may adjust the frequency band of the luminance frequency signal and the frequency band of the modulated color difference frequency signal by adjusting the frequency of the subcarrier.

Operation 340 of FIG. 3 may be performed after operation 830.

When operations 810 through 830 are performed, the processor 220 may convert, to the analog video signal, the digital video signal that includes the modulated color difference frequency signal.

In operation 350, the communicator 210 may transmit the analog video signal that includes the modulated color difference frequency signal.

A video signal reception apparatus for receiving a video signal using the modulated color difference frequency signal may decrease an alternating color issue and a luminance inclusion issue.

The technical description made above with reference to FIGS. 1 through 7 may be applicable as is and thus, further description will be omitted.

FIG. 9 illustrates an example of an analog video signal according to example embodiments.

An analog video signal 910 may include a luminance frequency signal 912 and a modulated color difference frequency signal 914. For example, a frequency band of the luminance frequency signal 912 may be 6 MHz. A frequency of a first subcarrier may be determined so that a frequency band of the modulated color difference frequency signal 914 is included in the frequency band of the luminance frequency signal 912.

The processor 220 may change a frequency of a subcarrier from the frequency of the first subcarrier to a frequency of a second subcarrier. The frequency of the second subcarrier may be a high frequency compared to the frequency of the first subcarrier.

An analog video signal 920 may include a luminance frequency signal 922 and a modulated color difference frequency signal 924. For example, a frequency band of the luminance frequency signal 922 may be 12 MHz.

Since the frequency of the second subcarrier corresponding to the high frequency is used, it is possible to decrease inclusion between a luminance signal and a color difference signal when converting the analog video signal 920 to a digital video signal.

The technical description made above with reference to FIGS. 1 through 8 may be applicable as is and thus, further description will be omitted.

The units and/or modules described herein may be implemented using hardware components, software components, and/or combination of the hardware components and the software components. For example, the apparatuses and the hardware components described herein may be implemented using, for example, a processor, a controller and an arithmetic logic unit (ALU), a digital signal processor, a microcomputer, a field programmable array (FPA), a programmable logic unit (PLU), a microprocessor, or one or more general-purpose computers or specific-purpose computers such as any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will be appreciated that a processing device may include multiple processing elements and/or multiple types of processing elements. For example, a processing device may include multiple processors or a processor and a controller. In addition, different processing configurations are possible, such a parallel processors.

The methods according to the above-described example embodiments may be recorded in non-transitory computer-readable media including program instructions to implement various operations of the above-described example embodiments. The media may also include, alone or in combination with the program instructions, data files, data structures, and the like. The program instructions recorded on the media may be those specially designed and constructed for the purposes of example embodiments, or they may be of the kind well-known and available to those having skill in the computer software arts. Examples of non-transitory computer-readable media include magnetic media such as hard disks, floppy disks, and magnetic tape; optical media such as CD-ROM discs, and DVDs; magneto-optical media such as optical media and floptical disks; and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The above-described hardware devices may be configured to act as one or more software modules in order to perform the operations of the above-described example embodiments, or vice versa.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

**Claims**

1. A video signal transmission method for converting a digital video signal to an analog video signal, the method comprising:

   receiving the digital video signal;
   determining a specification (spec) for transmitting the analog video signal;
   converting a first digital timing of the digital video signal to a second digital timing based on the spec;
   converting the digital video signal to the analog video signal; and
   transmitting the analog video signal.

2. The method of claim 1, wherein the converting of the first digital timing to the second digital timing comprises converting the first digital timing to the second digital timing based on a type of the digital video signal.

3. The method of claim 2, wherein the type of the digital video signal is at least one of a type in which a luminance signal and a color difference signal are separated and a type in which the luminance signal and the color difference signal are mixed.

4. The method of claim 1, wherein the converting of the first digital timing to the second digital timing comprises converting the first digital timing to the second digital timing based on a frame rate of the digital video signal.

5. The method of claim 1, wherein the converting of the first digital timing to the second digital timing comprises converting the first digital timing to the second digital timing so that the second digital timing is consistent with respect to the spec.

6. The method of claim 1, wherein the converting of the first digital timing to the second digital timing further comprises:

   determining a system frequency based on the spec; and
   generating the system frequency, and
   the converting of the first digital timing to the second digital timing comprises converting the first digital timing to the second digital timing based on the system frequency.

7. The method of claim 6, wherein the generating of the system frequency comprises generating the system frequency using a phase locked loop (PLL).

8. The method of claim 6, wherein the converting of the first digital timing to the second digital timing further comprises determining the second digital timing based on the system frequency.

9. The method of claim 1, wherein the converting of the first digital timing to the second digital timing comprises converting the first digital timing to the second digital timing by changing the number of samples in a blank area of the digital video signal.

10. The method of claim 9, wherein the number of samples in the blank area is determined based on the system frequency, and
the system frequency is determined based on the spec.

11. The method of claim 1, wherein a horizontal frequency of the digital video signal varies in response to converting the first digital timing to the second digital timing.

12. The method of claim 1, wherein the receiving of the digital video signal comprises receiving the digital video signal by synchronizing the digital video signal to an input clock.

13. The method of claim 1, further comprising:

    modulating a color difference frequency signal of the digital video signal using a subcarrier,
    wherein the transmitting of the analog video signal comprises transmitting the analog video signal that includes the modulated color difference frequency signal.

14. A video signal transmission apparatus for converting a digital video signal to an analog video signal, the apparatus comprising:

    a processor configured to determine a specification (spec) for transmitting the analog video signal, to convert a first digital timing of the digital video signal to a second digital timing based on the spec, and to convert the digital video signal to the analog video signal; and
    a communicator configured to receive the digital video signal and to transmit the analog video signal.

FIG. 1

DIGITAL
VIDEO SIGNAL

FREQUENCY
CONVERTER

CONVERTED
DIGITAL
VIDEO SIGNAL

TRANSMISSION
UNIT

ANALOG
VIDEO SIGNAL

100

**FIG. 2**

INPUT

OUTPUT

100

210
COMMUNICATOR

220
PROCESSOR

230
MEMORY

**FIG. 3**

```
        ┌─────────────┐
        │    START    │
        └──────┬──────┘
               ↓
  ┌──────────────────────────────┐
  │  RECEIVE DIGITAL VIDEO SIGNAL │ ～310
  └──────────────┬───────────────┘
                 ↓
  ┌──────────────────────────────────┐
  │ DETERMINE SPEC OF ANALOG VIDEO   │ ～320
  │            SIGNAL                 │
  └──────────────┬───────────────────┘
                 ↓
  ┌──────────────────────────────────┐
  │ CONVERT FIRST DIGITAL TIMING OF  │
  │ DIGITAL VIDEO SIGNAL TO SECOND   │ ～330
  │ DIGITAL TIMING BASED ON SPEC     │
  └──────────────┬───────────────────┘
                 ↓
  ┌──────────────────────────────────┐
  │  CONVERT DIGITAL VIDEO SIGNAL TO │ ～340
  │       ANALOG VIDEO SIGNAL        │
  └──────────────┬───────────────────┘
                 ↓
  ┌──────────────────────────────────┐
  │  TRANSMIT ANALOG VIDEO SIGNAL    │ ～350
  └──────────────┬───────────────────┘
                 ↓
        ┌─────────────┐
        │     END     │
        └─────────────┘
```

EP 3 107 283 A1

**FIG. 4**

START

DETERMINE SYSTEM FREQUENCY
BASED ON SPEC ~ 410

GENERATE SYSTEM FREQUENCY ~ 420

DETERMINE SECOND DIGITAL TIMING
BASED ON SYSTEM FREQUENCY ~ 430

CONVERT FIRST DIGITAL TIMING TO
SECOND DIGITAL TIMING ~ 440

END

14

EP 3 107 283 A1

FIG. 5

| 745 | 746 | 747 | 748 | 749 | 750 | 1 | 2 | 3 | 4 | 5 | 6 | 7 | 8 | 9 | 10 | 11 | 12 | 25 | 26 |

EQUALIZING
PULSES

SERRATION
PULSES

EQUALIZING
PULSES

VERTICAL
BLANKING
INTERVAL
(VBI)

ACTIVE
LINES

15

**FIG. 6**

BLANK     1280 SAMPLES

720 LINES

750 LINES

EAV     SAV

**FIG. 7**

710

720

## FIG. 8

START

SEPARATE LUMINANCE SIGNAL AND COLOR DIFFERENCE SIGNAL FROM DIGITAL VIDEO SIGNAL — 810

CONVERT LUMINANCE SIGNAL TO LUMINANCE FREQUENCY SIGNAL AND CONVERT COLOR DIFFERENCE SIGNAL TO COLOR DIFFERENCE FREQUENCY SIGNAL — 820

MODULATE COLOR DIFFERENCE FREQUENCY SIGNAL USING SUBCARRIER — 830

END

# FIG. 9

## 910

dB

912

914

FREQUENCY 6 MHz
OF FIRST
SUBCARRIER

## 920

dB

922

924

FREQUENCY 12 MHz
OF SECOND
SUBCARRIER

## INTERNATIONAL SEARCH REPORT

International application No.

**PCT/KR2014/010478**

| A. | CLASSIFICATION OF SUBJECT MATTER |
|---|---|

***H04N 7/01(2006.01)i***

According to International Patent Classification (IPC) or to both national classification and IPC

| B. | FIELDS SEARCHED |
|---|---|

Minimum documentation searched (classification system followed by classification symbols)
H04N 7/01; H04N 5/06; G09G 5/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: image, conversion

C. DOCUMENTS CONSIDERED TO BE RELEVANT

| Category* | Citation of document, with indication, where appropriate, of the relevant passages | Relevant to claim No. |
|---|---|---|
| Y | KR 10-2008-0007123 A (SONY CORPORATION) 17 January 2008 | 1,14 |
| A | See abstract, paragraphs [0057], [0076], [0113], claim 1, figure 1 | 2-13 |
| Y | KR 10-2004-0084390 A (NEOTEC. INC. et al.) 06 October 2004 | 1,14 |
| A | See abstract, pages 4, 5, claims 1, 6, figures 1, 2 | 2-13 |
| A | JP 10-028256A (MATSUSHITA ELECTRIC IND. CO., LTD.) 27 January 1998 | 1-14 |
|  | See abstract, paragraphs [0015]-[0021], [0028]-[0031], claim 1, figures 1, 2 | |
| A | KR 10-1992-0019186 A (SAMSUNG ELECTRONICS CO., LTD.) 22 October 1992 | 1-14 |
|  | See abstract, claim 1, figure 3 | |

| ☐ | Further documents are listed in the continuation of Box C. | ☒ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 03 FEBRUARY 2015 (03.02.2015) | **03 FEBRUARY 2015 (03.02.2015)** |

| Name and mailing address of the ISA/**KR** | Authorized officer |
|---|---|
| Korean Intellectual Property Office<br>Government Complex-Daejeon, 189 Seonsa-ro, Daejeon 302-701,<br>Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2014/010478**

| Patent document cited in search report | Publication date | Patent family member | Publication date |
|---|---|---|---|
| KR 10-2008-0007123 A | 17/01/2008 | CN 101106669 A<br>CN 101106669 C0<br>JP 04-131284B2<br>JP 2008-022436A<br>US 2008-0024659 A1 | 16/01/2008<br>16/01/2008<br>13/08/2008<br>31/01/2008<br>31/01/2008 |
| KR 10-2004-0084390 A | 06/10/2004 | KR 20-0318449 Y1 | 28/06/2003 |
| JP 10-028256A | 27/01/1998 | CA 2210196 A1<br>CA 2210196 C<br>DE 69731334 D1<br>DE 69731334 T2<br>EP 0818933 A2<br>EP 0818933 A3<br>EP 0818933 B1<br>KR 10-0255907 B1<br>US 6211918 B1 | 11/01/1998<br>25/05/2004<br>02/12/2004<br>17/03/2005<br>14/01/1998<br>11/11/1998<br>27/10/2004<br>01/05/2000<br>03/04/2001 |
| KR 10-1992-0019186 A | 22/10/1992 | JP 04-329087A | 17/11/1992 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020060063723